(19) Europäisches Patentamt
European Patent Office
Office européen des brevets

(11) **EP 0 310 632 B1**

(12) **EUROPEAN PATENT SPECIFICATION**

(45) Date of publication and mention
of the grant of the patent:
**20.03.1996 Bulletin 1996/12**

(21) Application number: **88900969.2**

(22) Date of filing: **11.12.1987**

(51) Int. Cl.$^6$: **B01D 71/02**, B01D 29/05,
B01D 29/52, B01D 46/12,
B01D 46/54, B01D 53/22,
B01D 63/06, C04B 35/00

(86) International application number: **PCT/US87/03269**

(87) International publication number:
**WO 88/07398 (06.10.1988 Gazette 1988/22)**

(54) **CROSS-FLOW FILTRATION DEVICE AND METHOD OF MANUFACTURING SAID DEVICE**

KREUZSTROM-FILTRATIONSAPPARAT UND VERFAHREN ZU DESSEN HERSTELLUNG

DISPOSITIF DE FILTRATION A ECOULEMENT TANGENTIEL ET PROCEDE DE FABRICATION

(84) Designated Contracting States:
**DE FR GB**

(30) Priority: **02.04.1987 US 33572**

(43) Date of publication of application:
**12.04.1989 Bulletin 1989/15**

(73) Proprietor: **CERAMEM CORPORATION
Waltham, MA 02154 (US)**

(72) Inventor: **CERAMEM CORPORATION
Waltham, MA 02154 (US)**

(74) Representative: **Cresswell, Thomas Anthony et al
J.A. KEMP & CO.
14 South Square
Gray's Inn
London WC1R 5LX (GB)**

(56) References cited:
EP-A- 0 002 422          EP-A- 0 121 445
EP-A- 0 170 025          EP-A- 0 270 051
FR-A- 2 313 962          FR-A- 2 445 163
FR-B- 2 061 934          US-A- 3 712 473
US-A- 3 737 043          US-A- 4 041 592
US-A- 4 568 456

**Description**

This invention relates to an improved cross-flow filtration device for separating a feed stock into filtrate and retentate, and more particularly to such a device having filtrate conduits with low flow resistance which provide enhanced filtrate removal from the interior of the device. This invention also relates to an improved membrane device which employs such a cross-flow filtration device as a membrane support.

There are a multitude of filtration devices which separate a feed stock into filtrate and retained suspended matter which is too large to pass through the pore structure of the filter. A straight-through filter retains the suspended matter on the filter surface or within the filter matrix and passes only the filtrate. Cross-flow filters operate with tangential flow across the filter surface to sweep away suspended matter unable to pass through the filter surface pores. Cross-flow filters provide for the continuous extraction of retentate, or concentrated suspended matter, from one portion of the device and continuous extraction of filtrate from another portion. As is well known in the art, the filtration rate of cross-flow filters is generally limited by the resistance of a filter cake that builds up on the filter surface. The thickness and corresponding resistance of this cake is controlled by the cross-flow velocity. This phenomenon of cake thickness controlled by concentration polarization of retained suspended matter is extensively described in the technical literature. In order to obtain the maximum filtration rate, cross-flow filters are normally constructed from porous materials which have a low resistance to filtrate flow relative to that of the filter cake. That is, in operation the pressure drop across the porous filter itself is low relative to the pressure drop across the filter cake, and the resistance of the latter is determined by hydrodynamic flow conditions across the filter surface.

FR-A-2 061 934 discloses filters which comprise assemblies of individual porous members shaped to provide rows of parallel feedstock passageways and optionally also rows of filtrate passageways perpendicular thereto.

Cross-flow filters can be constructed using multiple-passageway, porous monoliths (see EP-A-121 445 for example). Such monoliths can have tens to thousands of passageways extending through them, with the passageways normally parallel and uniformly spaced. When in use the feed stock is introduced under pressure at one end of the monolith, flows in parallel through the passageways, and is withdrawn as retentate at the downstream end of the device. Filtrate which passes into the porous monolith walls separating the passageways combines and flows through the walls toward the periphery of the monolith, and is removed through an integral, pressure-containing outer skin of the monolith. The resistance to flow in the tortuous flow path of the monolith passageway walls can severely limit filtration capacity, and for this reason cross-flow filters based on high surface area, multiple-passageway, porous monoliths are not found in commercial use.

Membrane devices utilize a semipermeable membrane to separate filtrate, also called permeate, from retentate. There is a multitude of different membrane devices which separate and concentrate particles, colloids, macromolecules, and low molecular weight molecules. Membranes generally require a mechanical support which can be integral with the membrane, as for self-supporting asymmetric membranes, or separate. For the latter, membranes can be coated onto, or simply mechanically supported by, a porous support material.

Multiple-passageway, porous monoliths can be especially useful as membrane supports. In this instance membranes are applied to the passageway walls, which serve both as a mechanical support and as the flow path for filtrate removal to a filtrate collection zone. A high flow resistance of the passageway walls of the monolith can be troublesome first in that it can prevent adequate formation of membranes, for example, by dynamic formation procedures. Second, if membranes are otherwise applied to the monolith passageway walls, the resistance of the passageway walls to filtrate flow can limit device capacity. This limitation has clearly been recognized by developers of such devices, for example, by Hoover and Roberts in U.S. Patent 4,069,157. That patent teaches a solution to such limitation by limiting a number of parameters to values within specific ranges. The surface area of the passageways per unit volume, the porosity of the support, and the proportion of the volume of the support material exclusive of the passageways to the total volume of the support are defined within certain ranges, and are combined to define an allowable range of a permeability factor for the support.

Other monolith-based membrane devices have been developed in the United States, France, and The People's Republic of China. For these devices practitioners also have recognized a support permeability limitation and have generally overcome this limitation by use of monoliths with combinations of small overall diameter, relatively few feed passageways and large pore size of the support material. One commercially-available membrane device utilizes a number of small diameter hexagonal monoliths, each with up to 19 passageways, distributed within a cylindrical housing. Filtrate exits from all six sides of each monolith and mixes with the filtrate from the other monoliths, after which it is collected. The overall packing density, or membrane area per unit volume, of this device is quite low.

The monoliths used by all the above sources as supports for membrane devices have had the common characteristic of employing passageways which are substantially uniformly spaced throughout the support. Given this constraint, product developers have worked with variables such as those detailed by Hoover and Roberts in the above referenced patent to avoid filtrate flow path limitations.

Thus the flow resistance of the passageway walls of porous monoliths can be a limiting factor in the use of monoliths either as cross-flow filtration devices or as membrane supports in membrane devices. Further, this limitation becomes increasingly severe as the packing density, or effective filter or membrane area per unit volume, of the device increases.

In the field of heat exchangers there are several conventional devices having a multiple flow path body. For the device of Kelm, U.S. Patent No. 4,041,592, for example, two fluids enter separately into a body, are maintained separately within the body, and exit separately. Thermal exchange occurs between the two fluids but there is no transfer of matter. Kelm suggests that a porous body can be utilized for the exchange of matter or the filtering of a fluid between flow paths, but no further teaching is provided.

This invention seeks to provide an improved cross-flow filtration device which readily removes filtrate from the device and which has a large amount of surface area of its passageways relative to the volume of the device.

The cross-flow filtration device of the invention effectively utilizes substantially all of its passageways by providing a low pressure drop flow path for filtrate between even the innermost passageways and a filtrate collection zone associated with the device.

The cross-flow filtration device of this invention enables the walls of the passageways to have smaller pore sizes while still providing adequate filtrate removal rates.

This invention results from the realization that truly effective filtrate removal for a cross-flow filtration device or a membrane device using a porous monolith having multiple passageways can be achieved by providing a number of discrete rows of filtrate conduit passageways distributed among rows of feedstock passageways to effectively carry filtrate toward a filtrate collection zone, each filtrate conduit passageway having a low flow resistance relative to the monolith passageway walls and rows of filtrate conduit passageways being separated by relatively few rows of feedstock passageways to ensure a favorable pressure drop from any passageway wall to a nearby conduit. A still further realization is that a conventional monolith with substantially uniformly spaced passageways can be readily converted into such a structure by selectively sealing existing passageways and establishing filtrate channels from those sealed passageways to a filtrate collection zone.

According to the invention there is provided a cross-flow filtration device for receiving a feedstock at a feed end face and for separating the feedstock into filtrate and retentate, comprising:

a single monolith of porous material defining (i) a plurality of rows of feedstock passageways extending longitudinally from the feed end face to a retentate end face of the monolith through which the feedstock flows to pass retentate from the device, (ii) a plurality of rows of filtrate conduit passageways extending parallel to said rows of feedstock passageways longitudinally along at least a portion of the length of the monolith and (iii) filtrate channels extending transversely from the rows of filtrate conduit passageways, each row of filtrate conduit passageways being separated from an adjacent row of filtrate conduit passageways by a plurality of rows of feedstock passageways; and means to isolate the filtrate conduit passageways and if necessary the filtrate channels from both end faces of the monolith,

the filtrate conduit passageways together with said filtrate channels providing flow paths of lower flow resistance than that of alternative flowpaths through the porous material and in use of the device carrying filtrate toward a filtrate collection zone.

The filtrate conduit passageways may extend longitudinally from the feed end to the retentate end of the structure. Alternatively, the filtrate conduit passageways may extend longitudinally with the feedstock passageways along at least a portion of the length of the monolith. The filtrate channels may be slots at an end of the monolith or holes formed in the monolith to connect the filtrate conduit passageways to the filtrate collection zone. Filtrate channels may be formed at both the feed end and the retentate end of the device.

In a preferred embodiment each filtrate channel is a transverse slot formed in at least one end face of the monolith for connecting unaltered longitudinal portions of respective rows of filtrate conduit passageways to a filtrate collection zone, each slot being sealed at an end face of the monolith.

In another preferred embodiment each filtrate channel is a transverse hole formed in the monolith to intersect each row of filtrate conduit passageways.

The barrier means, disposed at the feed and retentate ends of the monolith, for inhibiting direct passage of the feedstock and retentate into the filtrate conduit passageways may include plugs of the same material as the monolith, or other, and the plugs may have a porosity similar to or less than that of the monolith material. The surface area of the passageways is from 32.8 to 328 or 65.6 to 242m$^2$ per m$^3$ (100 to 1,000 or 200 to 800 square feet per cubic foot) of structure. The passageways are generally parallel to each other.

The filtrate conduit passageways may be filled with a packing material having a lower flow resistance than that of the porous material to provide mechanical support for the filtrate conduits. Alternatively, the filtrate conduit passageways are hollow. The rows of filtrate conduit passageways may be substantially equally spaced and are generally parallel to each other. The porous material may be a ceramic material selected from cordierite, alumina, mullite, silica, zirconia, titania, spinel, silicon carbide, or mixtures thereof. The porous material may have a porosity of about 20-60% and a mean pore size of 0.1 to 20 micronmeters. The cross-flow filtration device may further include a permselective membrane applied to the surfaces of the passageways and selected from the group of membranes suitable for cross-flow microfiltration, ultrafiltration, reverse osmosis, gas separations, or pervaporation.

This invention also features a method of forming filtrate conduits in a monolith of porous material having a plurality of passageways extending from an upstream end to a downstream end of the monolith, including selecting a number of rows of the passageways as filtrate conduit passageways for carrying filtrate from within the monolith to a filtrate collection zone. The rows of filtrate conduit passageways are distributed among the rows of non-selected passageways to provide low pressure drop flow paths from the non-selected passageways through the porous material to nearby filtrate conduit passageways. The method further includes establishing one or more filtrate channels to connect the filtrate conduit passageways to the filtrate collection zone, and sealing the filtrate conduit passageways to inhibit direct passage of fluid into the filtrate conduit passageways and the filtrate collection zone.

In one embodiment, the filtrate conduit passageways are sealed at the upstream and downstream ends of the monolith, and establishing each filtrate channel includes cutting a slot in an end of the monolith to form that channel. Alternatively, a hole is formed into the monolith to form that channel. The rows of filtrate conduit passageways may be substantially equally spaced and parallel. Each row of filtrate conduit passageways and associated channels may extend across the monolith. The monolith may have substantially uniformly spaced and axially spaced parallel passageways and may be made from a ceramic material.

The invention further provides a cross-flow filtration apparatus which comprises a device in accordance with the invention, a filtrate collection zone disposed externally of the monolith for collecting filtrate from the filtrate channels of said device and means for isolating the filtrate collection zone from the feed and retentate end faces of the monolith.

The invention will be further described by reference to the accompanying drawings, in which:

Fig. 1 is a schematic partial axonometric end view of a cross-flow filtration device according to this invention and formed from a conventional monolith manufactured with substantially equally spaced passageways;

Fig. 2 is an axonometric view of the cross-flow filtration device of Fig. 1 after completion;

Fig. 3 is a schematic axonometric view of yet another cross-flow filtration device according to this invention formed from a conventional monolith; and

Fig. 4 is a schematic partial axonometric partially cutaway view of a cross-flow filtration apparatus device comprising a cross-flow filtration device according to this invention.

A filtration device according to this invention is described as a cross-flow filtration device from which filtrate and retentate are extracted, but it is to be recognized that the invention also relates to a porous material used as a support for a membrane device from which permeate and retentate are extracted. Hereinafter, the term cross-flow filtration device encompasses a porous support structure for a membrane device and the term filtrate encompasses permeate extracted from a membrane device. Such membranes can include separation barriers suitable for cross-flow microfiltration, ultrafiltration, reverse osmosis, gas separations and pervaporation.

The cross-flow filtration device employs a single monolith having rows of filtrate conduit passageways formed within it. Each filtrate conduit passageway is supplied with filtrate from a relatively large number of feedstock passageways proximate to it, and which lie along its boundary as it extends toward the filtrate collection zone of the cross-flow filtration device. Further, each row of filtrate conduit passageways is separated from a neighboring row of filtrate conduit passageways by a relatively small number of rows of feedstock passageways. This ensures an adequately low pressure drop for filtrate flow from any feedstock passageway wall through intervening walls to a filtrate conduit passageway.

This invention may be accomplished by converting a conventional monolith having a number of passageways, typically substantially uniformly spaced, by sealing some of the passageways at each end and establishing filtrate channels from the sealed passageways to a filtrate collection zone. The modified passageways thus serve as filtrate conduits according to this invention.

The cross-flow filtration device 10 can be fabricated from a variety of porous materials, such as ceramics, plastics, or resin-impregnated solids such as sand. Among ceramics, it is desirable to use cordierite, alumina, mullite, silica, zirconia, titania, silicon carbide, spinel, or mixtures thereof. Acceptable porosities of the material range from 20 to 60 percent, preferably greater than 30 percent. The mean pore size, while selectable over a wide range, is typically in the range of about 0.1 to 20 micronmeters.

Selection of the parameters of a cross-flow filtration device according to this invention is assisted by the Kozeny-Carmen adaptation of Darcy's law:

$$Q/A = \frac{\varepsilon^3 \Delta P}{k' L \mu (1-\varepsilon)^2 S^2} \qquad (1)$$

where Q/A is the rate of mass flow through the porous medium, that is, volume flow per unit time per unit cross-sectional area; $\varepsilon$ is the porosity; $\Delta P$ is the pressure drop; k' is the Kozeny-Carmen constant (nominally having a value of 5); L is the flow length; $\mu$ is the fluid viscosity; and S is the surface area of the porous medium. Application of the Kozeny-Carmen equation is described, for example, in Dullien, F. A. L., "Single Phase Flow through Porous Media and Porous Structure," in the Chemical Engineering Journal (Lausanne), 10, 1-34 (1975).

The surface area S is related to the pore hydraulic diameter $D_H$ by the following relationship:

$$D_H = \frac{4\varepsilon}{(1-\varepsilon)S} \qquad (2)$$

For a given material, therefore, the rate of mass flow Q/A is related to pore size and other factors as follows:

$$Q/A = \frac{\varepsilon D_H^2 \Delta P}{16k'\mu L} \qquad (3)$$

The mean pore size is therefore very important in determining permeability of the passageway walls. While it would appear desirable to use the largest pored materials available, this is not necessarily possible. For cross-flow filtration the pore size determines separation effectiveness, and large pored materials may lack adequate separation efficiency. For use of monoliths as membrane supports, large pores may also be impractical. For example, Trulson and Litz in U.S. Patent 3,977,967 disclose that for inorganic membranes formed dynamically on microporous supports, when supports with pores larger than 2 micronmeters are used, fines in the particle suspensions used to form membranes can enter the support pore structure and plug the pores, resulting in undesirably low permeation rates. In contrast, the dynamic membrane formation procedures of Hoover and Roberts in U.S. Patent No. 4,069,157 allow for a preferred pore size of 10 to 17 micronmeters. Also, when inorganic membranes are formed by slip casting, larger pored supports may be used, as demonstrated by Alari et al., in U.S. Patent No. 4,562,021. Thus for monoliths used as membrane supports, the maximum pore size that can be used must be related to the technique employed for membrane formation. But, in general, it has been demonstrated that membranes are more readily formed on finer pored materials.

The construction of a cross-flow filtration device according to this invention, including its configuration and the fabrication material, depends on the intended use of the cross-flow filtration device. Considering the construction of cross-flow filtration device its filtrate flow characteristics can be calculated. For the purpose of this calculation it is assumed that the section has a uniformly distributed water filtrate flow into the monolith passageway walls of 41 $m^3/dm^2$ (1000 gallons per day per square foot geometric area (gfd)). If the device is used for cross flow filtration, this would be a typical and desirable filtration rate for many process applications. If the monolith device is to be used as a membrane support, the same filtrate flow level will be suitable for ultrafiltration and reverse osmosis devices, with resulting membrane device water fluxes of about 4.1 $m^3/dm^2$ (100 gfd) or greater. These membrane water flux levels are suitable for most process applications.

Given the assumption of a uniformly-distributed water filtrate flow of 41 $m^3/dm^2$ (1000 gfd), the pressure drop through the monolith passageway walls can be estimated. In the following sample calculation the parameters of the monolith are as follows: the porosity of the support material is 45%; the passageway density is 47 passageways per square cm (300 square passageways per square inch) with a passageway size of 1.1 mm (0.044 inch); the wall thickness is 300 $\mu$m (0.012 inch); and the passageway surface area is 2.1 $mm^{-1}$ (53 square inches per cubic inch). Using Equation (3) with a value of a Kozeny-Carmen constant of 5, the pressure drop for different numbers $\underline{n}$ of rows of feedstock passageways between the rows of filtrate conduit passageways and for different values of mean pore diameter $D_H$ is shown in Table 1. The pressure drop is expressed in bar (pounds per square inch (psi)).

TABLE 1

| | PRESSURE DROP, IN bar (PSI) | | |
|---|---|---|---|
| n | $D_H = 4\mu$ | $D_H = 2\mu$ | $D_H = 1\mu$ |
| 5 | 3.0 (44) | 12.0 (175) | 48.1 (698) |
| 10 | 12.6 (183) | 50.6 (734) | 202.1 (2932) |
| 20 | 51.2 (743) | 204.7 (2970) | 819.0 (11880) |

These calculations illustrate the dramatic increase in pressure drop from the feedstock passageways to a filtrate conduit passageway as the number of rows of feedstock passageways between rows of filtrate conduit passageways increases or pore size decreases. The pressure drop increases with the square of the number of passageways because both the filtrate flow (Q/A) and flow path length (L) increase in proportion to the number of passageways.

Similar calculations can be made for monoliths of different passageway dimensions, and the results of Table 2 illustrate such an analysis.

TABLE 2

| PRESSURE DROP TO FILTRATE CONDUITS, bar (PSI) | | | | | |
|---|---|---|---|---|---|
| PASSAGE-WAYS PER cm$^2$(SQ.mm $^{-1}$ IN.) | PASSAGEWAY AREA (SQ.IN./CU. IN.) | PASSAGEWAY SIZE, mm (IN.) | PASSAGEWAY WALL, mm (IN.) | LENGTH BETWEEN CONDUITS, mm (IN.) | PRESSURE DROP, bar (PSI) |
| 47 (300) | 2.1(53) | 1.1(0.044) | 0.30(0.012) | 6.9 (0.27) | 3.0 (44) |
| 31 (200) | 1.8 (46) | 1.5 (0.058) | 0.30 (0.012) | 8.6 (0.34) | 5.2 (75) |
| 16 (100) | 1.3 (33) | 2.1 (0.083) | 0.43 (0.017) | 12.2 (0.48) | 7.6 (110) |
| 8 (50) | 0.9 (23) | 2.9 (0.115) | 0.64 (0.025) | 17.3 (0.68) | 9.6 (140) |

These calculations are based on the dimensional properties of commercially available monoliths (without filtrate conduits) with square passageways, a porosity of 45%, a pore size of 4 micronmeters, and five rows of feedstock passageways between rows of filtrate passageways conduit. For this family of monolith materials the pressure drop from the center of the structure increases approximately in proportion to the distance between conduits. This reflects the interaction among the variables of Equation (3). Thus for this family of materials the critical parameter is the distance between filtrate conduits. Note that, from Table 1, for a fixed passageway size monolith the critical parameter is the square of the distance between conduits.

The construction selected for a device according to this invention also depends on the pressure under which the device operates. For ultrafiltration devices, for example, device operation typically occurs at 3.4 to 6.9 bar g (50 to 100 psig). For the monolith materials of Table 1 a preferred monolith substrate would have a 4-micrometer or larger pore size and five or fewer rows of feedstock passageways between rows of filtrate conduit passageway. For reverse osmosis devices, system operation typically occurs at 34 to 69 bar g (500 to 1000 psig), and a finer pore size material or a greater number of rows of feedstock passageways between rows of filtrate conduit passageway may be used.

Variations from these values would be required for different porosities, different fluids, different values of the Kozeny-Carmen constant (which is material dependent), and other variables. Also, the above calculations are based on the assumption of a uniformly distributed filtrate flow into passageway walls of 41 m$^3$/dm$^2$ (1000 gfd). This assumption is generally valid for devices which have a membrane applied to the passageway walls, for example, by solution casting or slip casting, and the membrane provides the major resistance to filtrate removal. For cross-flow filtration or dynamic membrane formation the assumption of uniform filtrate flow may not be valid. In these instances filtrate flow through the porous material will be very high adjacent to filtrate conduits and will diminish rapidly as the distance from the filtrate conduits increases. In this case the spacing of the rows of filtrate conduit passageway may need to be even smaller in order to obtain adequate filtrate flow through the passageway walls distant from the filtrate conduits. Alternatively, it may be necessary to use porous materials with greater pore size and porosity or thicker passageway walls. Based on these considerations different requirements may exist for porous materials used as supports for membranes, applied other than by dynamic formation, and for porous materials used as cross-flow filters or as supports for dynamically-formed membranes. But these typical results illustrate the limitation associated with the use of monoliths without filtrate conduits and the beneficial result of incorporation of such conduits. The presence of rows of filtrate conduit passageways as detailed herein results in the beneficial use of porous monoliths with passageway surface area in the range of 330 to 3300 m$^{-1}$ (100 to 1000 square feet per cubic foot), and preferably between 660 and 2620 m$^{-1}$ (200 and 800 square feet per cubic foot).

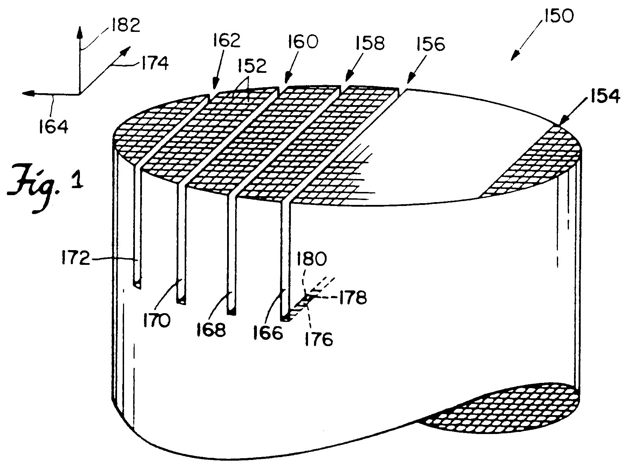

A cross-flow filtration device according to this invention can be constructed from a conventional monolith such as monolith 150, Fig. 1, having substantially equally spaced passageways 152. Conventional monolith 150 is converted as follows. Rows of passageways 152 are selected at intervals, e.g. every fifth or sixth row, as filtrate conduit passageways. Designated rows, such as rows 156, 158, 160 and 162 are selected along a first dimension 164. Row 154 represents a filtrate conduit row which has not yet been modified according to this invention. As shown, rows 156, 158, 160, 162 are substantially equally spaced in a first dimension 164 and are generally parallel to each other. These rows are shown having slots 166, 168, 170, and 172, respectively, cut into monolith 150. Slots 166, 168, 170, 172 serve as channels to connect the unaltered, longitudinal portions of the filtrate conduit passageways in the respective rows to a filtrate collection zone. Each row of filtrate conduit passageways operates as a filtrate conduit, and each passageway is a chamber of the filtrate conduit connected with a filtrate channel and separated from adjoining passageways in second dimension

6

174 by a single wall of the monolith material. For example, filtrate conduit passageways 176, 178 are separated by wall 180 and are both connected with slot 166.

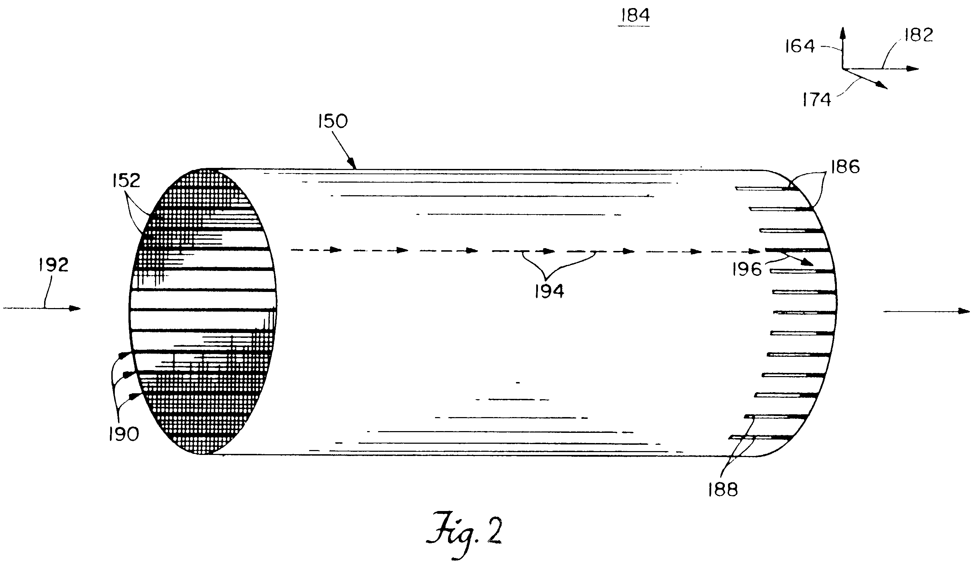

Once a slot is cut for each filtrate conduit row of passageways, each row is plugged at the feed and retentate ends of the monolith along dimension 174. Completed cross-flow filtration device 184, Fig. 2, has plugs 186 at the retentate end for each slot 188, and matching plugs 190 at the feed end for each row of filtrate conduit passageways.

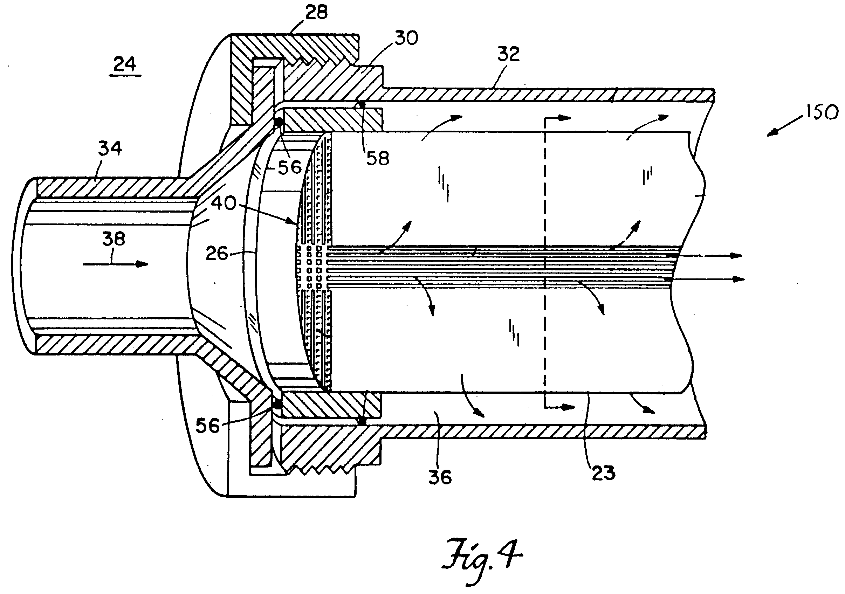

For use as a cross-flow filtration device, the modified monolith 150 is placed in an apparatus 24, Fig. 4. Feed flow, represented by arrow 192, enters the feed end of cross-flow filtration device 184. Filtrate passes through the walls of passageways 152 to enter the filtrate conduit passageways serving as filtrate conduits. Filtrate travels as shown by arrows 194, coinciding with dimension 182, until slots 188 are reached, at which point the filtrate flows along dimension 174, indicated by arrow 196.

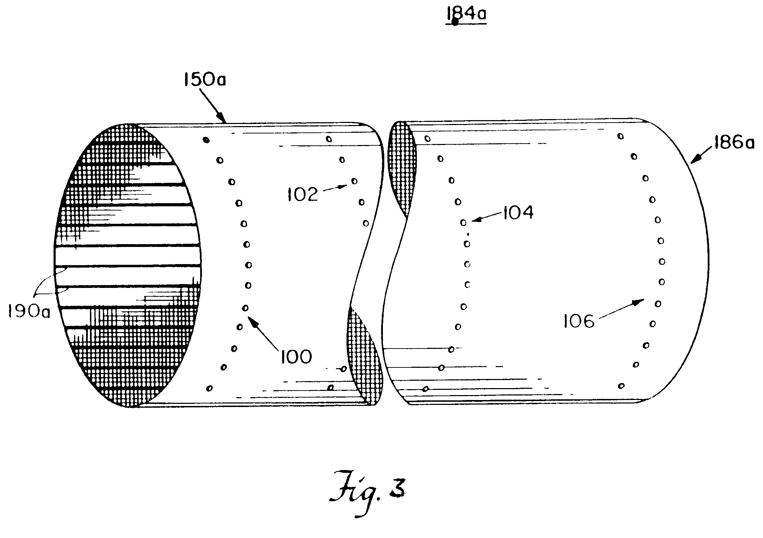

In alternative cross-flow filtration device 184a, Fig. 3, each filtrate conduit row has four sets of channels established by drilled holes 100, 102, 104, 106 which pass through the monolith 150a intersecting each filtrate conduit row. In another construction, only one set of holes is provided mid-way between the feed and retentate ends. Plugs 190a, 186a at the ends of monolith 150a prevent direct passage of feed or retentate fluid into the filtrate conduit passageways.

Providing channels at both ends of monolith device 150 or 150a for each filtrate conduit row is especially desirable for separations involving filtrate reflux, such as in certain gas separations.

Further, if required, the filtrate conduit passageways and the channels may be filled with a highly porous material to increase the mechanical support of passageway walls adjacent to filtrate conduit passageways and channels.

Cross-flow filtration device 150 according to this invention is part of a cross-flow filtration apparatus 24 as illustrated in Fig. 4. Cylindrical ring end fitting 26 is bonded with cement to outer monolith skin 23 of cylindrical cross-flow filtration device 150. Threaded end cap 28 engages matching threaded portion 30 of housing 32 and forcibly seals end fitting 26 against feed connecting pipe 34 with an O-ring seal 56. A second O-ring seal 58 is provided between cylindrical ring 26 and threaded portion 30 of housing 32. An alternate sealing procedure utilizes the end faces of outer skin 23 of cylindrical cross-flow filtration device 150 to seal to feed connecting pipe 34 through O-ring seal 56 and to threaded portion 30 of housing 32 through O-ring seal 58. Filtrate collection annulus 36 lies between skin 23 and housing 32.

In operation feed stock is forced under pressure in the direction indicated by arrow 38. Feed end 40 of cross-flow filtration device 150 receives the feedstock and passes the fluid longitudinally until it exits from the retentate end (not shown). Feed end 40 is shown in an enlarged, end view in Fig. 2 to reveal square openings of feedstock passageways 152, each defined and surrounded by passageway walls. Also shown are end plugs 190 for filtrate conduit passageways. Plugs 190 and 186 at feed and retentate ends of the monolith isolate filtrate conduit passageways, from direct contact with the feedstock or retentate. Along the interior of cross-flow filtration device 150 the walls of the feedstock passageways allow only the filtrate to enter filtrate conduit passageways. Plugs 190 and 186 can be of the same or a different material as the walls and are easily applied after masking the openings of passageways 152. The plugs are hardened by curing or firing, depending on composition, to provide a positive barrier between the feedstock and retentate, and the filtrate within filtrate conduit passageways. If plugs 190 and 186 are porous it is desirable that the pores in plugs 190 and 186 not be larger than those of the pasageway walls. The mechanical strength and chemical and thermal resistance of plugs 190 and 186 are selected according to the nature of the feedstock and intended operating pressure and temperature.

After entering feed end 40, Fig. 4, part of the fluid permeates into the filtrate conduit passageways along passageways 152. The filtrate is gradually removed and the impermeable retentate continues its passage along the feedstock passageways.

The following examples provide a comparison of monolith permeability for a conventional monolith and a monolith modified to have filtrate conduit passageways and channels according to this invention:

Example 1

A conventional monolith was assembled in an apparatus similar to that of Fig. 4. Cylindrical ceramic end rings 56 were bonded to the monolith ends using a silicone adhesive. The monolith, obtained from Corning Glass Works, Corning, New York, was a right cylinder 10 cm (four inches) in diameter and 15 cm (six inches long). The passageway configuration was square with 47 cells per $cm^2$ (300 cells per square inch), uniformly spaced. The passageway dimension was 1.1 mm (0.044 inch) and the passageway wall thickness was 0.30 mm (0.012 inch). The total passageway area through which filtrate could flow was about 2.6 $m^2$ (28 square feet), less the area of a few passageways adjacent to the monolith outer skin which were plugged by adhesive. The monolith material was cordierite EX-20 with a mean pore size of 3 to 4 micrometers and a porosity of 33 percent. After installation of the monolith in the apparatus of Fig. 4 the average water permeability, based on an estimated area of 2.4 $m^2$ (26 square feet), was measured to be 45 $m^3/dm^2$ (110 gfd) at 4.4°C (40°F) and a feed water pressure of 34 bar g (50 psig).

Example 2

A second monolith of the same material and passageway configuration was modified according to this invention to have filtrate conduits as shown in Figs. 1 and 2. The conduits were spaced every fifth row of passageways and plugged at the monolith ends with silicone adhesive. Slots were formed at one end of the monolith, and each slot had an opening length at the side of the monolith into the filtrate collection zone of approximately 13 mm (0.5 inch). The total passageway area available for filtrate flow was about 1.9 m$^2$ (20 square feet), allowing for a reduction in area from that of the original monolith of 20 percent for filtrate conduits and a lesser amount for passageways adjacent to the monolith skin which had been plugged by adhesive. The monolith was inserted into the apparatus used in example 1 and its water permeability was measured to be about 97.8 m$^3$/dm$^2$ (2400 gfd) at 4.4°C (40°F) and a feed water pressure of 34 bar g (50 psig).

The monolith of Example 2 experienced an increase in monolith permeability of 22-fold over the conventional monolith of Example 1, even though the second monolith exhibited a reduction in passageway area of about 20 percent. Subsequent cross-flow microfiltration tests of the monolith of Example 2 with a highly turbid suspension of colloidal zirconia showed a filtrate completely free of turbidity. This demonstrated that the measured high permeability was not due to any leak or bypassing in the module but resulted from the operation of the filtrate conduits according to this invention.

While a square array of square passageways is used for the above examples, it is to be recognized that other passageway shapes, such as round or triangular, and other arrays, such as hexagonally spaced, may be employed. Further, in the above examples essentially parallel filtrate conduits are described, but it is to be recognized that alternative conduit configurations, such as ones aligned on the radii of a cylindrical monolith, may be employed.

**Claims**

1.  A cross-flow filtration device (184) for receiving a feedstock (192) at a feed end face and for separating the feedstock (192) into filtrate and retentate, comprising:
    a single monolith (150) of porous material defining (i) a plurality of rows of feedstock passageways (152) extending longitudinally from the feed end face to a retentate end face of the monolith through which the feedstock flows to pass retentate from the device, (ii) a plurality of rows of filtrate conduit passageways (156, 158, 160, 162) extending parallel to said rows of feedstock passageways (152) longitudinally along at least a portion of the length of the monolith (150) and (iii) filtrate channels (166, 168, 170, 172 or 100, 102, 104, 106) extending transversely from the rows of filtrate conduit passageways (156, 158, 160, 162), each row of filtrate conduit passageways (say 156) being separated from an adjacent row of filtrate conduit passageways (say 158) by a plurality of rows of feedstock passageways (152); and
    means (186, 190 ; 186a, 190a) to isolate the filtrate conduit passageways and if necessary the filtrate channels from both end faces of the monolith (150),
    the filtrate conduit passageways together with said filtrate channels providing flow paths of lower flow resistance than that of alternative flowpaths through the porous material and in use of the device carrying filtrate toward a filtrate collection zone.

2.  A cross-flow filtration device according to claim 1 in which each filtrate channel is a transverse slot (166, 168, 170, 172) formed in at least one end face of the monolith (150) for connecting unaltered longitudinal portions of respective rows of filtrate conduit passageways (156, 158, 160, 162) to a filtrate collection zone, each slot (166, 168, 170, 172) being sealed (186) at an end face of the monolith (150).

3.  A cross-flow filtration device according to claim 1 in which each filtrate channel is a transverse hole (100, 102, 104, 106) formed in the monolith to intersect each row of filtrate conduit passageways.

4.  A cross-flow filtration device according to any one of the preceding claims in which the monolith porous material is a ceramic material.

5.  A cross-flow filtration device according to any one of the preceding claims which further comprises a permselective membrane applied to the surfaces of the feedstock passageways (152).

6.  A cross-flow filtration device according to claim 5 in which the permselective membrane is selected from membranes suitable for cross-flow filtration, ultra filtration, reverse osmosis, gas separation or pervaporation.

7.  A cross-flow filtration device according to any one of the preceding claims wherein the surface area of the feedstock passageways (152) is 32.8 to 328 m$^2$ per m$^3$ of monolith volume (100 to 1000 ft$^2$ per ft$^3$).

8. A cross-flow filtration device according to any one of the preceding claims wherein the rows of feedstock passageways (152) and of filtrate conduit passageways (156, 158, 160, 162) are planar.

9. A cross-flow filtration device according to claim 8 wherein each row of filtrate conduit passageways (say 156) is separated from an adjacent row of filtrate conduit passageways (say 158) by four or five rows of feedstock passageways (152).

10. A cross-flow filtration apparatus (24) which comprises a device (10) as claimed in any one of the preceding claims, a filtrate collection zone (36) disposed externally of the monolith (150) for collecting filtrate from the filtrate channels of said device and means (58) for isolating the filtrate collection zone (36) from the feed and retentate end faces of the monolith (150).

**Patentansprüche**

1. Querstrom-Filtrationseinrichtung (184) zum Aufnehmen eines Ausgangsmaterials (192) an einer Zuführungsendfläche und zum Trennen des Ausgangsmaterials (192) in Filtrat und Retentat, mit:
   einem einzigen Monolithen (150) aus porösem Material, der folgendes bildet: (i) eine Vielzahl von Reihen an Ausgangsmaterialdurchgängen (152), die sich in Längsrichtung ausgehend von der Zuführungsendseite zu einer Retentatendseite des Monolithen erstrecken, durch den das Augangsmaterial fließt, um das Retentat aus der Einrichtung auszuscheiden, (ii) eine Vielzahl von Reihen an Filtratleitungsdurchgängen (156, 158, 160, 162), die sich parallel zu den Reihen der Ausgangsmaterialdurchgänge (152) in Längsrichtung entlang mindestens einem Teil der Länge des Monolithen (150) erstrecken, und (iii) Filtratkanäle (166, 168, 170, 172 oder 100, 102, 104, 106), die sich quer zu den Reihen der Filtratleitungsdurchgänge (156, 158, 160, 162) erstrecken, wobei jede Reihe der Filtratleitungsdurchgänge (z.B. 156) von einer benachbarten Reihe von Filtratleitungsdurchgängen (z.B. 158) durch eine Vielzahl von Reihen an Ausgangsmaterialdurchgängen (152) getrennt sind; und
   Mitteln (186, 190; 186a, 190a) zum Isolieren der Filtratleitungsdurchgänge und, falls notwendig, der Filtratkanäle gegenüber den beiden Endseiten des Monolithen (150), wobei die Filtratleitungsdurchgänge zusammen mit den Filtratkanälen Durchflußwege mit einem Strömungswiderstand vorsehen, der niedriger als der von alternativen Durchflußwegen durch das poröse Material ist, und bei Verwendung der Einrichtung das Filtrat zu einer Filtratsammelzone befördern.

2. Querstrom-Filtrationseinrichtung nach Anspruch 1, bei der jeder Filtratkanal ein quergerichteter Schlitz (166, 168, 170, 172) ist, der in mindestens einer Endfläche des Monolithen ((150) ausgebildet ist, um unveränderte Längsabschnitte der jeweiligen Reihen der Filtratleitungsdurchgänge (156, 158, 160, 162) mit einer Filtratsammelzone zu verbinden, wobei jeder Schlitz (166, 168, 170, 172) an einer Endfläche des Monolithen (150) abgedichtet ist (186).

3. Querstrom-Filtrationseinrichtung nach Anspruch 1, bei der jeder Filtratkanal ein quergerichtetes Loch (100, 102, 104, 106) ist, das in dem Monolithen so ausgebildet ist, daß es jede Reihe der Filtratleitungsdurchgänge schneidet.

4. Querstrom-Filtrationseinrichtung nach einem der vorhergehenden Ansprüche, bei der das poröse Monolithmaterial ein Keramikmaterial ist.

5. Querstrom-Filtrationseinrichtung nach einem der vorhergehenden Ansprüche, die außerdem eine permselektive Membran umfaßt, die auf den Oberflächen der Ausgangsmaterialdurchgänge (152) aufgebracht ist.

6. Querstrom-Filtrationseinrichtung nach Anspruch 5, bei der die permselektive Membran aus Membranen ausgewählt wird, die sich für die Querstrom-Filtration ,Ultrafiltration, Umkehrosmose, Gasabscheidung oder Pervaporation eignen.

7. Querstrom-Filtrationseinrichtung nach einem der vorhergehenden Ansprüche, bei der der Oberflächenbereich der Ausgangsmaterialdurchgänge (152) 32,8 bis 328 $m^2$ pro $m^3$ des Monolithrauminhalts (100 bis 1000 $ft^2$ pro $ft^3$) beträgt.

8. Querstrom-Filtrationseinrichtung nach einem der vorhergehenden Ansprüche, bei der die Reihen der Ausgangsmaterialdurchgängen (152) und der Filtratleitungsdurchgänge (156, 158, 160, 162) planar sind.

9. Querstrom-Filtrationseinrichtung nach Anspruch 8, bei der jede Reihe der Filtratleitungsdurchgänge (z.B. 156) von einer benachbarten Reihe von Filtratleitungsdurchgängen (z.B. 158) durch vier oder fünf Reihen der Ausgangsmaterialdurchgänge (152) getrennt ist.

**10.** Querstrom-Filtrationsvorrichtung (24), die eine Einrichtung (10), wie sie in jedem der vorhergehenden Ansprüchen beansprucht wird, eine Filtratsammelzone (36), die sich außerhalb des Monolithen (150) befindet, um das Filtrat aus den Filtratkanälen der Einrichtung zu sammeln, und Mittel (58) zum Isolieren der Filtratsammelzone (36) gegenüber den Zuführungs- und Retentatendflächen des Monolithen (150) umfaßt.

## Revendications

**1.** Dispositif de filtration à écoulement transversal (184) destiné à recevoir une charge d'alimentation (192) sur une face d'extrémité d'alimentation et séparer la charge d'alimentation (192) en un filtrat et une matière retenue, comprenant :

un seul monolithe (150) formé d'un matériau poreux, définissant (i) une pluralité de rangées de passages (152) pour la charge d'alimentation, qui s'étendent longitudinalement depuis la face d'extrémité d'alimentation jusqu'à une face d'extrémité de matière retenue du monolithe, dans lesquelles la charge d'alimentation circule pour transférer la matière retenue, à partir du dispositif, (ii) une pluralité de rangées de passages (156,158,160,162) formant conduits pour le filtrat, qui s'étendent parallèlement auxdites rangées de passages (152) pour la charge d'alimentation, longitudinalement le long d'au moins une partie de la longueur du monolithe (150), et (iii) des canaux (166,168, 170,172 ou 100,102,104,106) de filtrat, qui s'étendent transversalement par rapport aux rangées de passages (156,158,160,162) formant conduits pour le filtrat, chaque rangée de passages (par exemple 156) formant conduits pour le filtrat étant séparée d'une rangée adjacente de passages (par exemple 158) formant conduits pour le filtrat par une pluralité de rangées de passages (152) pour la charge d'alimentation; et

des moyens (186,190;186a,190a) pour isoler les passages formant conduits pour le filtrat et, si cela est nécessaire, les canaux de filtrat par rapport aux deux faces d'extrémité du monolithe (150),

les passages formant conduits pour le filtrat formant, conjointement avec lesdits canaux de filtrat, des trajets à l'écoulement présentant une résistance d'écoulement inférieure à celle d'autres trajets d'écoulement à travers le matériau poreux et, lorsque le dispositif fonctionne, véhiculant le filtrat en direction d'une zone de collecte du filtrat.

**2.** Dispositif de filtration à écoulement transversal selon la revendication 1, dans lequel chaque canal de filtrat est une fente transversale (166,168,170,172) formée dans au moins une face d'extrémité du monolithe (150) pour le raccordement de parties longitudinales non modifiées de rangées respectives de passages (156,158,160,162) formant conduits pour le filtrat, à une zone de collecte de filtrat, chaque fente (166,168,170,172) étant fermée de façon hermétique (186) au niveau d'une face d'extrémité du monolithe (150).

**3.** Dispositif de filtration à écoulement transversal selon la revendication 1, dans lequel chaque canal de filtrat est un trou transversal (100,102,104,106) formé dans le monolithe de manière à couper chaque rangée de passages formant conduits pour le filtrat.

**4.** Dispositif de filtration à écoulement transversal selon l'une quelconque des revendications précédentes, dans lequel le matériau poreux du monolithe est un matériau céramique.

**5.** Dispositif de filtration à écoulement transversal selon l'une quelconque des revendication précédentes, qui comporte en outre une membrane à perméabilité sélective, appliquée sur les surfaces des passages (152) pour la charge d'alimentation.

**6.** Dispositif de filtration à écoulement transversal selon la revendication 5, dans lequel la membrane à perméabilité sélective est choisie parmi des membranes convenant pour la filtration à écoulement transversal, l'ultrafiltration, l'osmose inverse, la séparation des gaz ou l'évaporation à travers une membrane.

**7.** Dispositif de filtration à écoulement transversal selon l'une quelconque des revendications précédentes, dans lequel l'aire de la surface des passages (152) pour la charge d'alimentation est comprise entre 32,8 et 328 $m2$ par $m3$ du volume du monolithe (100 à 1000 pieds2 par pied3).

**8.** Dispositif de filtration à écoulement transversal selon l'une quelconque des revendications précédentes, dans lequel les rangées de passages (152) pour la charge d'alimentation et de passages (156,158,160,162) formant conduits pour le filtrat sont planes.

**9.** Dispositif de filtration à écoulement transversal selon la revendication 8, dans lequel chaque rangée de passages (par exemple 156) formant conduits pour le filtrat est séparée d'une rangée adjacente de passages (par exemple 158) formant conduits pour le filtrat, par quatre ou cinq rangées de passages (152) pour la charge d'alimentation.

**10.** Dispositif de filtration à écoulement transversal (24), qui comprend un dispositif (10) tel que revendiqué dans l'une quelconque des revendications précédentes, une zone (36) de collecte de filtrat disposée à l'extérieur du monolithe (150) pour collecter le filtrat à partir des canaux de filtrat dudit dispositif, et des moyens (58) pour isoler la zone (36) de collecte de filtrat, par rapport aux faces d'extrémité d'alimentation et de matière retenue, du monolithe (150).

EP 0 310 632 B1

Fig. 1

12

*Fig.* 2

EP 0 310 632 B1

184a

150a

190a

102

104

100

106

186a

Fig. 3

EP 0 310 632 B1

Fig. 4